# EUROPÄISCHE PATENTSCHRIFT

(11) **EP 0 970 550 B1**
(45) Veröffentlichungstag und Bekanntmachung des Hinweises auf die Patenterteilung: **28.05.2003**
(21) Anmeldenummer: 98923997.5
(22) Anmeldetag: 12.03.1998
(51) Int. Cl.: H01S 5/022, H01S 5/0687

(54) **LASERMODUL MIT WELLENLÄNGENSTABILISIERUNG**
LASER MODULE WITH WAVELENGTH STABILIZATION
MODULE LASER AVEC STABILISATION DE LA LONGUEUR D'ONDE

(30) Priorität: 26.03.1997 DE 19712845
(43) Veröffentlichungstag der Anmeldung: 12.01.2000
(73) Patentinhaber: Infineon Technologies AG, 81669 München (DE)
(72) Erfinder: AURACHER, Franz, D-82065 Baierbrunn (DE); MÄRZ, Reinhard, D-81667 München (DE)
(74) Vertreter: Epping, Wilhelm, Dipl.-Ing.
(86) Internationale Anmeldenummer: DE9800737
(87) Internationale Veröffentlichungsnummer: WO98043327

(56) Entgegenhaltungen:
- EP-A- 0 660 467
- DE-A- 4 429 748
- US-A- 5 299 212
- PATENT ABSTRACTS OF JAPAN vol. 006, no. 107 (E-113), 17. Juni 1982 & JP 57 037893 A (MITSUBISHI ELECTRIC CORP), 2. März 1982
- PATENT ABSTRACTS OF JAPAN vol. 017, no. 199 (E-1352), 19. April 1993 & JP 04 342183 A (ANRITSU CORP), 27. November 1992
- PATENT ABSTRACTS OF JAPAN vol. 017, no. 629 (E-1462), 19. November 1993 & JP 05 198883 A (ANDO ELECTRIC CO LTD), 6. August 1993
- PATENT ABSTRACTS OF JAPAN vol. 012, no. 367 (E-664), 30. September 1988 & JP 63 119284 A (MATSUSHITA ELECTRIC IND CO LTD), 23. Mai 1988
- PATENT ABSTRACTS OF JAPAN Bd. 199, Nr. 511 26 Dezember 1995 & JP 07 202 311 A (NEC CORP) 04 August 1995

## Beschreibung

Halbleiterlaser enthaltende Lasermodule für optische Übertragungssysteme mit Wellenlängenmultiplex-Technik (WDM-Technik) müssen während der gesamten geforderten Lebensdauer (10⁵ Stunden) ihre Wellenlänge sehr stabil halten, damit sich die Übertragungseigenschaften im Wellenlängenkanal nicht unzulässig ändern bzw. kein Übersprechen auf Nachbarkanäle auftritt. Derzeit sind vorwiegend WDM-Systeme mit 4 und 8 Wellenlängenkanälen mit einem Kanalabstand von 400 Ghz (entspricht 3.2 nm) bzw. 200 Ghz (entspricht 1.6 nm) im Einsatz. Die Zahl der Wellenlängenkanäle wird sich jedoch in Kürze auf 16 und mittelfristig auf 32 bis 64 Kanäle erhöhen, wobei sich der Kanalabstand entsprechend der höheren Kanalzahl verkleinern wird.

Bei den heute eingesetzten Lasermodulen wird die Feineinstellung und Stabilisierung der Wellenlänge ausschließlich über die Temperatur der Laserdiode bewirkt. Die typische Änderung der Wellenlänge für 1.5 µm-Halbleiterlaser liegt z.B. bei 0.1 nm/K Temperaturänderung. Diese indirekte Wellenlängenstabilisierung hat den Nachteil, daß sie Alterungseffekte der Laserdiode in keiner Weise berücksichtigt. Führende Hersteller von Lasermodulen garantieren derzeit eine Wellenlängenstabilität von 0.3 nm innerhalb der Lebensdauer. Dieser Wert ist jedoch für zukünftige leistungsfähige WDM-Übertragungssysteme mit kleinerem Kanalabstand nicht ausreichend.

In der US 5,299,212 ist ein wellenlängenstabilisierter Halbleiterlaser beschrieben, bei dem der Laserstrahl mit zwei Strahlteilern in drei Anteile aufgespalten wird. Je 5% der Strahlung gelangen direkt bzw. über ein filterndes Gitter in Detektoren, deren Messwerte ins Verhältnis gesetzt werden. Über eine Kontrollschaltung wird die Wellenlänge so nachreguliert, dass dieses Verhältnis mit einem vorgegebenen Wert übereinstimmt. In der JP 7 202 311 ist ein Verfahren zum Stabilisieren der Wellenlänge eines Halbleiterlasers beschrieben, bei dem ebenfalls ein Verhältnis aus einem Anteil der Laserstrahlung und einem weiteren Anteil einer bestimmten ausgefilterten Wellenlänge zur Kontrolle benutzt wird, um über eine Temperatureinstellung die emittierte Wellenlänge konstant zu halten.

Aufgabe der vorliegenden Erfindung ist es, ein Lasermodul mit einer Wellenlängenstabilisierung der erwähnten Art anzugeben, das einfach herstellbar und besonders zweckmäßig in optischen Übertragungssystemen mit WDM-Technik einsetzbar ist. Diese Aufgabe wird mit dem Lasermodul mit den Merkmalen des Anspruchs 1 gelöst. Ausgestaltungen ergeben sich aus den abhängigen Ansprüchen.

Bei dem Lasermodul wird ein Interferenzfilter als optisches Filter verwendet, das in das Lasermodul eingebaut ist. Da das Filter ein passives Bauelement ist, kann generell eine hohe Langzeit-Wellenlängenstabilität erreicht werden. Ein besonderer Vorteil der erfindungsgemäße Anordnung ist in der Konzeption zu sehen, die eine problemlose Integration zusammen mit einem Halbleiterlaser oder in einem ganzen Sendemodul auf der Oberfläche eines Substrats mit einfachen herkömmlichen Herstellungstechniken erlaubt.

Die Erfindung, wie sie in den Ansprüchen 1-4 definiert ist, wird bevorzugterweise in optischen Sendemodulen mit Halbleiterlasern verwendet zur Langzeitstabilisierung einer Wellenlänge des Lasers. Mit der Erfindung lassen sich vorteilhafterweise optische Festfrequenzquellen für die Sensorik realisieren.

Die Erfindung wird in der nachfolgenden Beschreibung anhand der Figuren beispielhaft näher erläutert. Es zeigen:
- Figuren 1 bis 4: jeweils in Draufsicht und stark vereinfachter Darstellung vier unterschiedliche grundlegende Ausführungsformen der erfindungsgemäßen Anordnung,
- Figuren 5 und 6: in schematischer Darstellung ein Filter in Form eines Bragg-Gitters bzw. in Form eines Richtkopplers oder Interferometers (Beispiele, die nicht Teil der Erfindung sind),
- Figur 7: in schematischer Schnittdarstellung eine Realisierung einer Ausgestaltung der Ausführungsform nach Figur 1
- Figur 8: in schematischer Schnittdarstellung eine Realisierung einer Ausgestaltung der Ausführungsform nach Figur 2,
- Figur 9: in schematischer Schnittdarstellung eine Realisierung einer Ausgestaltung der Ausführungsform nach Figur 4,
- Figur 10: in schematischer Schnittdarstellung eine Realisierung einer Ausgestaltung der Ausführungsform nach Figur 4.

Die Figuren sind nicht maßstäblich.

Bei der in den Figuren jeweils beispielhaft dargestellten erfindungsgemäßen Anordnung ist erfindungswesentlich das optische Filter 2, dem ein zu filternder Leistungsanteil P2 der vom Laser 1 abgestrahlten optischen Gesamtleistung P0 zugeführt ist und das aus diesem zugeführten Leistungsanteil P2 eine Leistung p2 ausfiltert, die im wesentlichen nur die zu stabilisierende Wellenlänge λ enthält.

Die ausgefilterte Leistung p2 wird gemessen, indem sie einem optischen Detektor 3 zur Detektion zugeführt wird.

Von der vom Laser 1 abgestrahlten optischen Gesamtleistung P0 ist ein weiterer Leistungsanteil P3 derart abgeleitet, daß ein Verhältnis p2/P3 zwischen der ausgefilterten Leistung p2 und dem weiteren Leistungsanteil P3 unabhängig von dieser Gesamtleistung P0 ist. Beispielsweise ist dies der Fall, wenn sowohl die ausgefilterte Leistung p2 als auch der weitere Leistungsanteil P3 jeweils proportional zur Gesamtleistung P0 sind, da sich dann die im Verhältnis p2/P3 sowohl im Zähler als auch Nenner vorkommende Gesamtleistung P0 herauskürzt.

Der weitere Leistungsanteil P3 wird gemessen, indem er einem weiteren optischen Detektor 4 zur Detektion zugeführt wird.

Es wird das Verhältnis p2/P3 zwischen der gemessenen bzw. detektierten ausgefilterten Leistung p2 und dem gemessenen bzw. detektierten weiteren Leistungsanteil P3 gebildet. Dazu ist eine Einrichtung 5 zur Bildung dieses Verhältnisses p2/P3 vorgesehen.

Das gebildete Verhältnis p2/P3 wird als ein Istwert mit einem einstellbaren Sollwert S0 dieses Verhältnisses p2/P3 verglichen und bei einer Abweichung des Istwerts p2/P3 vom jeweils eingestellten Sollwert S0 wird ein Betriebsparameter des Lasers 1, von dem die zu stabilisierende Wellenlänge λ abhängt, derart eingestellt, daß der Istwert p2/P3 im wesentlichen mit dem eingestellten Sollwert S0 übereinstimmt. Dazu ist eine Einrichtung 6 zur Durchführung dieses Vergleichs und derartigen Einstellung des Parameters vorgesehen. Der Parameter kann beispielsweise die Temperatur T des Lasers 1 sein.

Als Filter 2 sind alle Typen optischer Filter, insbesondere Hochpässe, Tiefpässe oder Bandpässe, die eine Filterkante ohne "Ripple" aufweisen, geeignet.

Die Einrichtung 5 kann aus einem herkömmlichen Quotientenbildner bestehen.

Die Einrichtung 6 ist vorzugsweise ein Regler, wobei als Regler sowohl analoge P-, besser PI- oder PID-Regler, als auch digitale Regler in Frage kommen.

Die geforderte Steilheit der Filterkante folgt aus der spektralen Auflösung und dem Einfangbereich der Regelung.

Der Temperaturgang des Filters 2 ist üblicherweise und insbesondere bei Filtern 2 auf Glasbasis wesentlich kleiner als der des Lasers 1, beispielsweise eine Laserdiode, so daß der Arbeitspunkt über den gesamten Temperaturbereich in der zur Regelung verwendeten Filterkante des Filters 2 bleibt. Die Temperaturüberwachung bzw. Regelung im Modul kann dann zusätzlich eingesetzt werden, um die Temperaturabhängigkeit der Transmissionskurve des Filters 2 auszumergeln, beispielsweise durch eine geeignete Schaltung oder eine Mikroprozessorsteuerung.

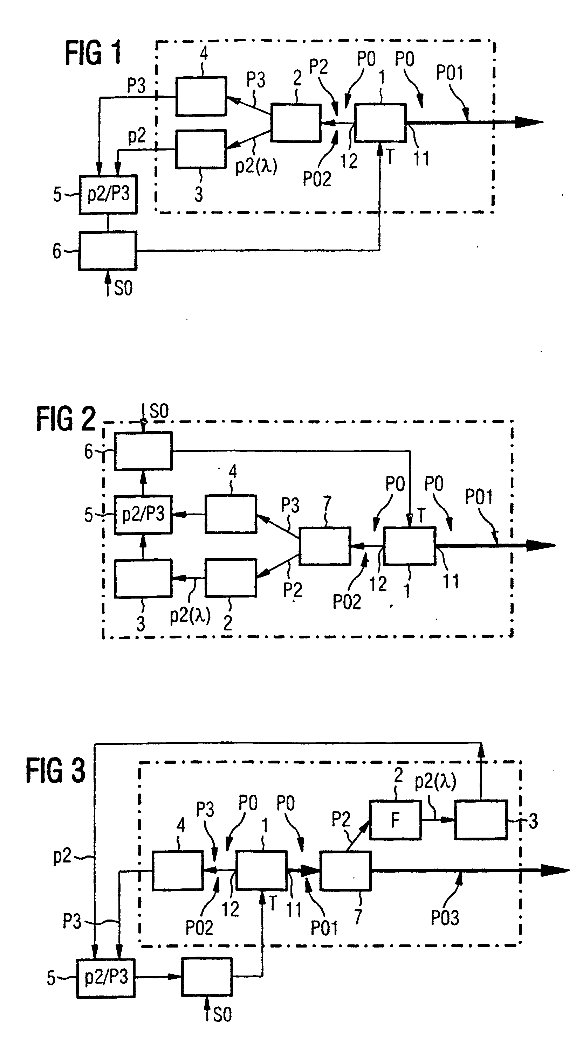

Bei der in Figur 1 dargestellten ersten grundlegenden Ausführungsform der erfindungsgemäßen Anordnung ist dem Filter 2 ein zur optischen Gesamtleistung P0 proportionaler zu filternder Leistungsanteil P2 zugeführt, so daß die von diesem Filter 2 ausgefilterte und im wesentlichen nur die zu stabilisierende Wellenlänge λ enthaltende Leistung p2 ebenfalls proportional zur Gesamtleistung P0 ist.

Dem weiteren Detektor 4 ist als weiterer Leistungsanteil P3 ein vom Filter 2 neben der ausgefilterten Leistung p2 abgegebener übriger Teil des zugeführten zu filternden Leistungsanteils P2 zugeleitet, wobei die Summe P3+p2 aus diesem übrigen Teil P3 und der ausgefilterten Leistung p2 gleich oder zumindest proportional zu dem zugeführten zu filternden Leistungsanteil P2 ist, so daß auch dieser weitere Leistungsanteil P3 proportional zur Gesamtleistung P0 ist.

Das Filter 2 besteht bei der Ausführungsform nach Figur 1 vorzugsweise aus einem optischen Interferenzfilter. Solche Interferenzfilter sind bekannt. Es könnten beispielhaft auch Bragg-Gitter als Filter ausgewälelt werden.

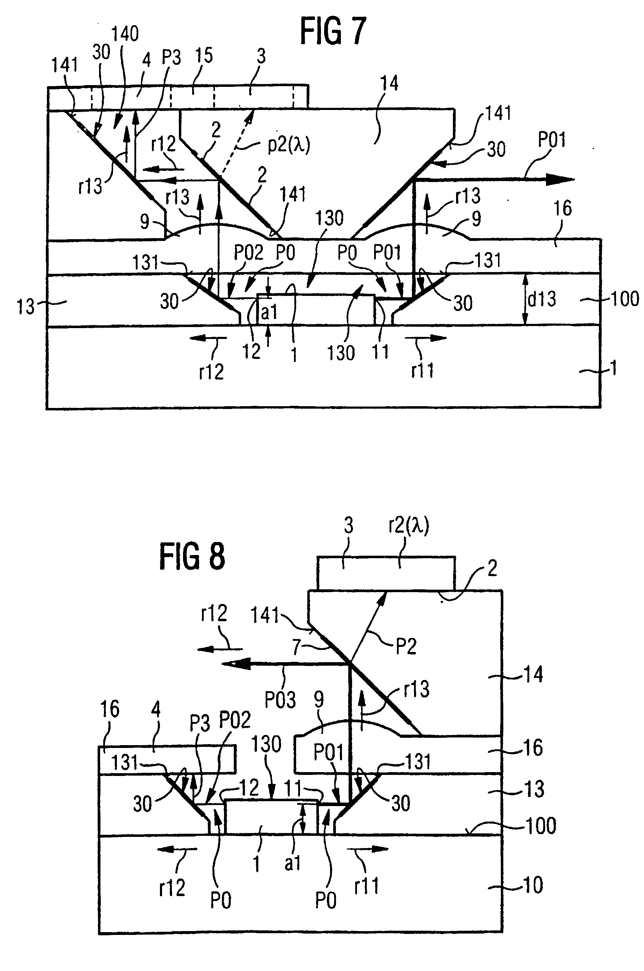

Ist dieses Filter 2 beispielsweise ein Interferenzfilter, bei dem die ausgefilterte Leistung p2 der vom Filter 2 transmittierte Teil des zugeführten Leistungsanteils P2 ist, wird dem einen Detektor 3 dieser transmittierte Leistungsanteil p2 und dem weiteren Detektor 4 der vom Filter 2 reflektierte übrige Teil des zugeführten Leistungsanteils P2 als der weitere Leistungsanteil P3 zugeführt. Bei dem später beschriebenen Ausführungsbeispiel nach Figur 7 ist ein solches Interferenzfilter verwendet.

Ist dagegen die ausgefilterte Leistung p2 der vom Interferenzfilter 2 reflektierte Teil des zugeführten Leistungsanteils P2, wird dem einen Detektor 3 dieser reflektierte Leistungsanteil p2 und dem weiteren Detektor 4 der vom Filter 2 transmittierte übrige Teil des zugeführten Leistungsanteils P2 als der weitere Leistungsanteil P3 zugeführt.

Ein Filter 2 in Form eines bekannten Bragg-Gitters ist in der Figur 5 in stark vereinfacht angedeutet. An den Gitterlinien 20 dieses Gitters wird gemäß einer bekannten Wirkungsweise der Bragg-Gitter ein im wesentlichen nur die zu stabilisirende Wellenlänge λ enthaltender und die ausgefilterte Leistung p2 bildender Teil des in einer bestimmten Richtung r zugeführten zu filternden Leistungsanteils P2 aus dieser Richtung r in eine andere Richtung r1 abgelenkt und dem einen Detektor 3 zugeführt. Der im wesentlichen unabgelenkt in der Richtung r aus dem Gitter austretende übrige Teil des zugeführten zu filternden Leistungsanteils P2 ist als der weitere Leistungsanteil P3 dem weiteren Detektor 4 zugeführt. Als Bragg-Gitter sind insbesondere auch Faser-Bragg-Gitter geeignet.

Das Filter 2 könnte als Beispiel bei der Anordnung nach Figur 1 auch aus einem aus der Gruppe der wellenlängenselektiven optischen Richtkoppler und Interferometer bestehen und nicht aus einem Interferenzfilter.

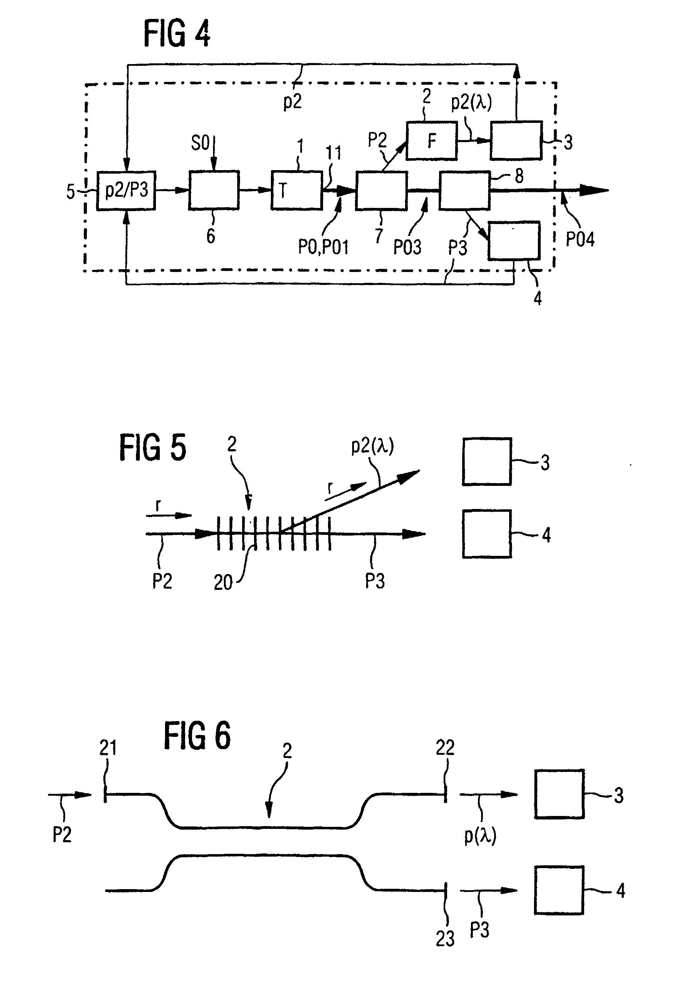

In diesem Fall weist dieses Filter 2 gemäß einem bekannten Aufbau eines solchen Kopplers oder Interferometers und wie in Figur 6 gezeigt ein Eingangstor 21 zum Einkoppeln des zugeführten zu filternden Leistungsanteils P2 in das Filter 2, ein Ausgangstor 22 zum Auskoppeln eines im wesentlichen nur die zu stabilisierende Wellenlänge λ enthaltenden und die ausgefilterte Leistung p2 bildenden Teils des zugeführten zu filternden Leistungsanteils P2 aus dem Filter 2 und ein weiteres Ausgangstor 23 zum Auskoppeln des den weiteren Leistungsanteil P3 bildenden übrigen Teils des zugeführten zu filternden Leistungsanteils P2 aus dem Filter 2 auf. Diese Art Auskopplung aus den Ausgangstoren 22 und 23 beruht auf der wellenlängenselektiven Wirkung, die solchen Kopplern und Interferometern bekanntermaßen gegeben werden kann.

Die aus dem einen Ausgangstor 22 ausgekoppelte ausgefilterte Leistung p2 ist dem einen Detektor 3 und der aus dem anderen Ausgangstor 23 ausgekoppelte weitere Leistungsanteil P3 dem weiteren Detektor 4 zugeführt.

Bei den in den Figuren 2 bis 4 dargestellten weiteren grundlegenden Ausführungsformen der erfindungsgemäßen Anordnung ist wie bei der Ausführungsform nach Figur 1 dem Filter 2 ein zur optischen Gesamtleistung P0 des Lasers 1 proportionaler zu filternder Leistungsanteil P2 und dem einen Detektor 3 die von diesem Filter 2 ausgefilterte und im wesentlichen nur die zu stabilisierende Wellenlänge λ enthaltende Leistung p2 zugeführt.

Im Unterschied zur Ausführungsform nach Figur 1 ist dem weiteren Detektor 4 als weiterer Leistungsanteil P3 ein von der optischen Gesamtleistung P0 des Lasers 1 abgeleiteter und zu dieser Gesamtleistung P0 proportionaler Leistungsanteil zugeführt, der von dem vom Filter 2 zu filternden Leistungsanteil P2 getrennt ist und von diesem Filter 2 ungefiltert bleibt.

Während bei der Ausführungsform nach Figur 1 das Filter 2 bei der Erzeugung des weiteren Leistungsanteils P3 für den weiteren Detektor 4 mit herangezogen ist, wird dieses Filter 2 bei den Ausführungsformen nach den Figuren 2 bis 4 bei der Erzeugung des weiteren Leistungsanteils P3 für den weiteren Detektor 4 nicht benutzt, sondern umgangen.

Die in den Figuren 2 bis 4 dargestellten Ausführungsformen können wie folgt unterschieden werden:

Bei den Ausführungsformen nach den Figuren 2 und 3 weist der Laser 1 zwei Lichtaustrittsfenster 11 und 12 zum jeweiligen Abstrahlen je einer Teilleistung P01 bzw. P02 der vom Laser 1 erzeugten optischen Gesamtleistung P0 auf. Eine der beiden Teilleistungen P01 bzw. P02, beispielsweise die Teilleistung P01 aus dem Lichtaustrittsfenster 11, ist für eine Nutzung, beispielsweise eine optische Leistungsübertragung oder optische Signal- oder Informationsübertragung bestimmt. Der dem Filter 2 zugeführte zu filternde Leistungsanteil P2 und der dem weiteren Detektor 4 zugeführte weitere Leistungsanteil P3 stammt ausschließlich von der anderen Teilleistung, im Beispiel der Teilleistung P02, die im dargestellten Fall beispielsweise nicht für eine Nutzung bestimmt ist, es aber auch sein könnte.

Es sei in diesem Zusammenhang darauf hingewiesen, daß bei der dargestellten Ausgestaltung der Ausführungsform nach Figur 1 beispielsweise ähnliche Verhältnisse vorliegen.

Bei der Ausführungsform nach Figur 4 stammt dagegen der dem Filter 2 zugeführte Leistungsanteil P2 und der dem weiteren Detektor 4 zugeführte weitere Leistungsanteil P3 von einer gleichzeitig für die Nutzung bestimmten optischen Leistung des Lasers 1. In diesem Fall kann ein Laser 1 mit nur einem Lichtaustrittsfenster 11 oder 12, aus dem die für die Nutzung bestimmte optische Gesamtleistung P0 des Lasers 1 austritt, verwendet werden. Der Laser 1 kann aber auch wie bei den Ausführungsformen nach den Figuren 1 bis 3 zwei Lichtaustrittsfenster 11 und 12 zum jeweiligen Abstrahlen je einer Teilleistung P01 bzw. P02 der vom Laser 1 erzeugten optischen Gesamtleistung P0 aufweisen, wobei die Teilleistung P01 oder die Teilleistung P02 die für die Nutzung bestimmte Leistung ist, von welcher der dem Filter 2 zugeführte Leistungsanteil P2 und der dem weiteren Detektor 4 zugeführte weitere Leistungsanteil P3 abgeleitet ist. Die jeweils andere Teilleistung P02 bzw. P01 kann für einen anderen Zweck oder ebenfalls eine Nutzung bestimmt sein.

In jedem Fall besteht bei der Ausführungsform nach Figur 4 der Vorteil, daß auch bei Verwendung eines Lasers 1 mit zwei Lichtaustrittsflächen 11 und 12 Alterungseffekte, die das Leistungsverhältnis zwischen den aus den zwei Lichtaustrittsflächen 11 und 12 abgestrahlten Teilleistungen P01 und P02 beeinflussen, keine Auswirkungen auf die erfindungsgemäße Wellenlängenstabilisierung haben.

Jede der Ausführungsformen nach den Figuren 2 bis 4 ist bevorzugterweise so ausgebildet, daß sie einen bekannten wellenlängenneutralen optischen Leistungsteiler 7, d.h. einen Teiler, dessen Teilungsverhältnis unabhängig von der Wellenlänge λ ist, aufweist, dem eine zur optischen Gesamtleistung P0 proportionale optische Leistung des Lasers 1, beispielsweise diese Gesamtleistung P0 selbst oder eine Teilleistung P01 oder P02 dieser Gesamtleistung P0, zugeführt ist. Dieser Teiler 7 erzeugt aus der zugeführten Leistung P0, P01 oder P02 zwei Leistungsanteile, deren einer dem Filter 2 als der zu filternde Leistungsanteil P2 zugeführt ist.

In bezug auf die im folgenden beschriebenen vorteilhaften und bevorzugten Ausgestaltungen der Ausführungsformen nach den Figuren 1 bis 4 sei angenommen, daß bei den Ausgestaltungen der Ausführungsformen nach den Figuren 1 bis 3 der Laser 1 ein Halbleiterlaser ist und zwei voneinander abgekehrte Lichtaustrittsfenster 11 und 12 zum jeweiligen Abstrahlen je einer Teilleistung P01 und P02 der vom Laser 1 erzeugten optischen Gesamtleistung P0 aufweist und nur die Teilleistung P01 oder P02 aus einem Lichtaustrittsfenster 11 oder 12, in der Darstellung die Teilleistung P01 aus dem Lichtaustrittsfenster 11, für eine Nutzung bestimmt ist.

Bei der Ausgestaltung der Ausführungsform nach Figur 1 ist die zur Gesamtleistung P0 proportionale Teilleistung P02 bzw. P01 aus dem anderen Lichtaustrittsfenster 12 bzw. 11, in der Darstellung die Teilleistung P02, selbst dem Filter 2 als der zu filternde Leistungsanteil P2 zugeführt.

Das Filter 2 spaltet den zu filternden Leistungsanteil P2 in die ausgefilterte Leistung p2, die im wesentlichen nur die zu stabilisierende Wellenlänge λ enthält und dem einen Detektor 3 zugeführt ist, und den übrigen Teil dieses zu filternden Leistungsanteils P2 auf, der als weiterer Leistungsanteil P3 dem weiteren Detektor 4 zugeführt ist.

Bei der Ausgestaltung der Ausführungsform nach Figur 2 ist die zur Gesamtleistung P0 proportionale Teilleistung P02 bzw. P01 aus dem anderen Lichtaustrittsfenster 12 bzw. 11, in der Darstellung die Teilleistung P02, dem wellenlängenneutralen Leistungsteiler 7 zugeführt, der diese Teilleistung P02 bzw. P01 in zwei Leistungsanteile aufspaltet, deren einer dem Filter 2 als der zu filternde Leistungsanteil P2 und andere dem weiteren Detektor 4 als der weitere Leistungsanteil P3 zugeführt ist.

Die vom Filter 2 aus dem zugeführten zu filternden Leistungsanteil P2 ausgefilterte und im wesentlichen nur die zu stabilisierende Wellenlänge λ enthaltende Leistung p2 ist dem einen Detektor 3 zugeführt.

Bei der Ausgestaltung der Ausführungsform nach Figur 3 ist dagegen die zur Gesamtleistung P0 proportionale eine Teilleistung P01 oder P02 aus dem einen Lichtaustrittsfenster 11 oder 12 dem wellenlängenneutralen Leistungsteiler 7 zugeführt, der diese Teilleistung P01 bzw. P02, in der Darstellung die Teilleistung P01, in zwei Leistungsanteile aufspaltet, deren einer dem Filter 2 als der zu filternde Leistungsanteil P2 zugeführt und andere für die Nutzstrahlung bestimmt mit P03 bezeichnet ist.

Die vom Filter 2 aus dem zu filternden Leistungsanteil P2 ausgefilterte und im wesentlichen nur die zu stabilisierende Wellenlänge λ enthaltende Leistung p2 ist dem einen Detektor 3 zugeführt.

Die zur Gesamtleistung P0 proportionale Teilleistung P02 bzw. P01 aus dem anderen Lichtaustrittsfenster 12 bzw. 11, in der Darstellung die Teilleistung P02, ist selbst dem weiteren Detektor 4 als der weitere Leistungsanteil P3 zugeführt.

Bei der Ausgestaltung der Ausführungsform nach Figur 4 sei angenommen, daß der Laser 1 ein Halbleiterlaser ist und ein Lichtaustrittsfenster 11 oder 12 zum Abstrahlen einer zur Gesamtleistung P0 proportionalen optischen Leistung, die jeweils für eine Nutzung bestimmt ist und die Gesamtleistung P0 selbst oder eine Teilleistung P01 oder P02 sein kann und in der Darstellung die Teilleistung P01 aus dem Lichtaustrittsfenster 11 ist.

Diese optische Leistung P0, P01 oder P02, in der Darstellung die Leistung P01, ist dem wellenlängenneutralen Leistungsteiler 7 zugeführt, der sie in zwei Leistungsanteile aufspaltet, deren einer für die Nutzung bestimmt und mit P03 bezeichnet ist.

Dieser eine Leistungsanteil P03 ist einem weiteren wellenlängenneutralen Leistungsteiler 8 zugeführt, der diesen Leistungsanteil P03 wiederum in zwei Leistungsanteile aufspaltet, deren einer für die Nutzung bestimmt und mit P04 bezeichnet ist.

Der von einem der beiden Leistungsteiler 7 und 8, beispielsweise dem Leistungsteiler 7 erzeugte andere Leistungsanteil ist dem Filter 2 als der zu filternde Leistungsanteil P2 und der vom anderen, in diesem Fall dem Leistungsteiler 8 erzeugte andere Leistungsanteil als der weitere Leistungsanteil P3 dem weiteren Detektor 4 zugeführt.

Der vom Filter 2 aus dem zugeführten zu filternden Leistungsanteil P2 ausgefilterte und im wesentlichen nur die zu stabilisierende Wellenlänge λ enthaltende Leistungsanteil p2 ist dem einen Detektor 3 zugeführt.

In den Figuren 7 bis 10 sind bevorzugte und vorteilhafte Realisierungen der vorstehend beschriebenen Ausgestaltungen der Ausführungsformen nach den Figuren 1 bis 4 im Schnitt dargestellt, wobei in der Schnittebene die optischen Achsen liegen, längs der sich die optischen Leistungen ausbreiten. Diese Realisierungen zeigen alle den besonderen Vorteil der Erfindung auf, der in der einfachen monolithischen Integration zusammen mit dem Laser 1 in Form eines Halbleiterlasers zu sehen ist.

Demgemäß ist bei jeder dieser Realisierungen der Laser 1 und die dieser Realisierung zugrundeliegende Ausführungsform der erfindungsgemäßen Anordnung auf der Oberfläche 100 eines gemeinsamen Substrats 10 angeordnet und ausgebildet.

Der Laser 1 selbst ist auf dieser Oberfläche 100 so angeordnet und ausgebildet, daß jedes seiner Lichtaustrittsfenster 11 und 12 in einem Abstand al von der Oberfläche 100 angeordnet ist und sich die von diesem Lichtaustrittsfenster 11 und/oder 12 abgestrahlte optische Leistung P0, P01 oder P02 in Richtung r11 und/oder r12 parallel zur Oberfläche 100 ausbreitet.

Weist der Laser 1 wie zumindest bei den Ausführungsformen nach den Figuren 1 bis 3 zwei zueinander entgegengesetzte Lichtaustrittsfenster 11 und 12 auf, sind auch die Richtungen r11 und r12, in denen sich die von diesen Lichtaustrittsfenstern 11 und 12 abgestrahlten Teilleistungen P01 und P02 ausbreiten, zueinander entgegengesetzt.

Bei den Realisierungen nach den Figuren 7 bis 9 sind für die erfindungsgemäße Anordnung auf der Oberfläche 100 zusätzlich mehrere Schichten aufgebracht.

Unmittelbar auf der Oberfläche 100 ist eine erste Schicht 13 aufgebracht, in der eine Aussparung 130 ausgebildet ist, in welcher die Oberfläche 100 freiliegt und der Laser 1 angeordnet ist. Diese Schicht 13 weist eine Schichtdicke d13 auf, die größer als der Abstand al jedes Lichtaustrittsfensters 11 und 12 des Lasers 1 von der Oberfläche 100 ist, und die Aussparung 130 weist gegenüber zumindest einem Lichtaustrittsfenster 11 und/oder 12 des Lasers 1 eine schräg in einem Winkel zur Oberfläche 100 stehende Randfläche 131 auf, die von der von diesem Lichtaustrittsfenster 11 und/oder 12 abgestrahlten optischen Leistung P0, P01 oder P02 getroffen wird.

Diese schräge Randfläche 131 ist verspiegelt und derart schräg zur Oberfläche 100 angeordnet, daß sie einen Umlenkspiegel 30 zum Umlenken der auftreffenden optischen Leistung P0, P01 oder P02 aus dem gegenüberliegenden Lichtaustrittsfenster 11 und/oder 12 des Lasers 1 in Richtung r13 nach oben von der Oberfläche 100 des Substrats 10 fort bildet.

Den Realisierungen nach den Figuren 7 bis 9 ist gemeinsam, daß eine in Richtung r13 nach oben sich ausbreitende optische Leistung P0, P01 oder P02 auf zumindest einen Umlenkspiegel 30 trifft, der diese auftreffende Leistung in eine Richtung parallel zur Oberfläche 100 des Substrats 10, beispielsweise in die Richtung r11 oder r12 umlenkt. Dieser Umlenkspiegel 30 besteht vorzugsweise aus einer schräg in einem Winkel zur Oberfläche 100 des Substrats 10 angeordneten verspiegelten Randfläche 141 einer auf oder über der ersten Schicht 13 ausgebildeten weiteren Schicht 14.

Der Winkel, in dem eine Randfläche 131 und/oder 141 schräg zur Oberfläche 100 des Substrats 10 angeordnet ist, beträgt vorzugsweise 45°, so daß in Richtung r11 und r12 oder in Richtung r13 sich ausbreitende optische Leistung durch einen Umlenkspiegel 30 jeweils um 90° umgelenkt wird.

Bei der in Figur 7 dargestellten Realisierung der Ausgestaltung der Ausführungsform nach Figur 1 breitet sich beispielsweise die aus dem rechten Lichtaustrittsfenster 11 des Lasers 1 austretende und für eine Nutzung bestimmte Teilleistung P01 der vom Laser 1 abgestrahlten optischen Gesamtleistung P0 in der Richtung r11 nach rechts aus und trifft auf den diesem Lichtaustrittsfenster 11 gegenüberliegenden Umlenkspiegel 30 der Schicht 13. Dieser Umlenkspiegel 30 lenkt diese Teilleistung P01 in die Richtung r13 nach oben zum Umlenkspiegel 30 der Schicht 14 um, von dem sie wieder in die Richtung r11 umgelenkt wird und danach für die Nutzung zur Verfügung steht.

Die aus dem linken Lichtaustrittsfenster 12 des Lasers 1 austretende und sich in der Richtung r12 nach links ausbreitende andere Teilleistung P02 der vom Laser 1 abgestrahlten optischen Gesamtleistung P0 ist für die Wellenlängenstabilisierung bestimmt. Sie trifft zunächst auf den diesem linken Lichtaustrittsfenster 12 gegenüberliegenden Umlenkspiegel 30 der Schicht 13. Dieser Umlenkspiegel 30 lenkt diese andere Teilleistung P02 in die Richtung r13 nach oben zum Filter 2 um und bildet den zu filternden Leistungsanteil P2.

Das Filter 2 ist in Form eines schichtförmigen Interferenzfilters auf einer schräg in einem Winkel zur Oberfläche 100 des Substrats 10 angeordneten und von der den die Teilleistung P01 umlenkenden Umlenkspiegel 30 bildenden Randfläche 141 der Schicht 14 abgekehrten Randfläche 141 der Schicht 14 ausgebildet und wirkt so, daß von dem zugeführten zu filternden Leistungsanteil P2 die im wesentlichen nur die zu stabilisierende Wellenlänge λ enthaltende auszufilternde Leistung p2 transmittiert und der übrige Teil dieses Leistungsanteils P2 als der weitere Leistungsanteil P3 reflektiert wird.

Die transmittierte Leistung p2 ist durch die Schicht 14 hindurch dem auf dieser Schicht 14 ausgebildeten einen Detektor 3 zugeführt.

Der reflektierte weitere Leistungsanteil P3 ist dem weiteren Detektor 4 zuzuführen.

Nach Figur 7 ist diese Zuführung beispielsweise so realisiert, daß die schräge Randfläche 141, auf der das Filter 2 ausgebildet ist, eine in der Schicht 14 ausgebildete Aussparung 140 begrenzt und so schräggestellt ist, daß sich der vom Filter 2 reflektierte weitere Leistungsanteil P3 in dieser Aussparung 140 in der Richtung r12 bis zu einer dem Filter 2 gegenüberliegenden, schräg in einem Winkel zur Oberfläche 100 des Substrats 10 angeordneten Randfläche 141 der Aussparung 140 ausbreitet, die verspiegelt ist und einen Umlenkspiegel 30 bildet, der den weiteren Leistungsanteil P3 in die Richtung r13 von der Oberfläche 100 fort nach oben umlenkt.

Auf der Schicht 14 ist eine Schicht 15 aufgebracht, welche die Aussparung 140 überragt oder überbrückt und in der im Bereich der Aussparung 140 der weitere Detektor 4 so ausgebildet und angeordnet ist, daß der weitere Leistungsanteil P3 auf ihn trifft.

In dieser Schicht 15 kann vorteilhafterweise auch der eine Detektor 3 ausgebildet sein.

Bei der in Figur 8 dargestellten Realisierung der Ausgestaltung der Ausführungsform nach Figur 2 breitet sich wie bei der Realisierung nach Figur 7 die aus dem rechten Lichtaustrittsfenster 11 des Lasers 1 austretende und für eine Nutzung bestimmte Teilleistung P01 der vom Laser 1 abgestrahlten optischen Gesamtleistung P0 in der Richtung r11 nach rechts aus und trifft auf den diesem Lichtaustrittsfenster 11 gegenüberliegenden Umlenkspiegel 30 der Schicht 13. Dieser Umlenkspiegel 30 lenkt diese Teilleistung P01 in die Richtung r13 nach oben um, jedoch nicht wie bei der Realisierung nach Figur 7 zu einem Umlenkspiegel 30, sondern zum wellenlängenneutralen Leistungsteiler 7 um, der die zugeführte Teilleistung P01 in zwei Leistungsanteile aufspaltet, deren einer als der zu filternde Leistungsanteil P2 dem Filter 2 zugeführt ist und mit P03 bezeichnete andere für die Nutzung zur Verfügung steht.

Der Leistungsteiler 7 ist in Form eines teildurchlässigen Spiegels auf einer schräg in einem Winkel zur Oberfläche 100 des Substrats 10 angeordneten Randfläche 141 der Schicht 14 ausgebildet und wirkt so, daß von der zugeführten Teilleistung P01 der dem Filter 2 zuzuführende zu filternde Leistungsanteil P2 transmittiert und der andere Leistungsanteil P03, der für die Nutzung zur Verfügung steht, reflektiert wird.

Der transmittierte Leistungsanteil P2 ist durch die Schicht 14 hindurch dem auf dieser Schicht 14 ausgebildeten Filter 2 zugeführt. Auf dem Filter 2 ist der eine Detektor 3 angeordnet, der die vom Filter 2 ausgefilterte und im wesentlichen nur die zu stabilisierende Wellenlänge λ enthaltende Leistung p2 empfängt.

Nach Figur 8 ist die schräge Randfläche 141, auf welcher der Leistungsteiler 7 ausgebildet ist, so schräggestellt, daß sich der vom Leistungsteiler 7 reflektierte Leistungsanteil P03 in der zur Richtung r11 entgegengesetzten Richtung r12 von der Schicht 14 fort ausbreitet.

Die aus dem linken Lichtaustrittsfenster 12 des Lasers 1 austretende und sich in der Richtung r12 nach links ausbreitende andere Teilleistung P02 der vom Laser 1 abgestrahlten optischen Gesamtleistung P0 trifft auf den diesem linken Lichtaustrittsfenster 12 gegenüberliegenden Umlenkspiegel 30 der Schicht 13. Dieser Umlenkspiegel 30 lenkt diese andere Teilleistung P02 in die Richtung r13 nach oben um.

Auf der Schicht 13 ist eine Schicht 16 aufgebracht, welche die Aussparung 130 überragt oder überbrückt und in der im Bereich der Aussparung 130 der weitere Detektor 4 so ausgebildet und angeordnet ist, daß die nach oben umgelenkte Teilleistung P02 als der weitere Leistungsanteil P3 auf ihn trifft.

Die Schicht 16 darf nicht die Ausbreitung des vom Leistungsteiler 7 reflektierten und für die Nutzung zur Verfügung stehenden Leistungsanteils P03 stören.

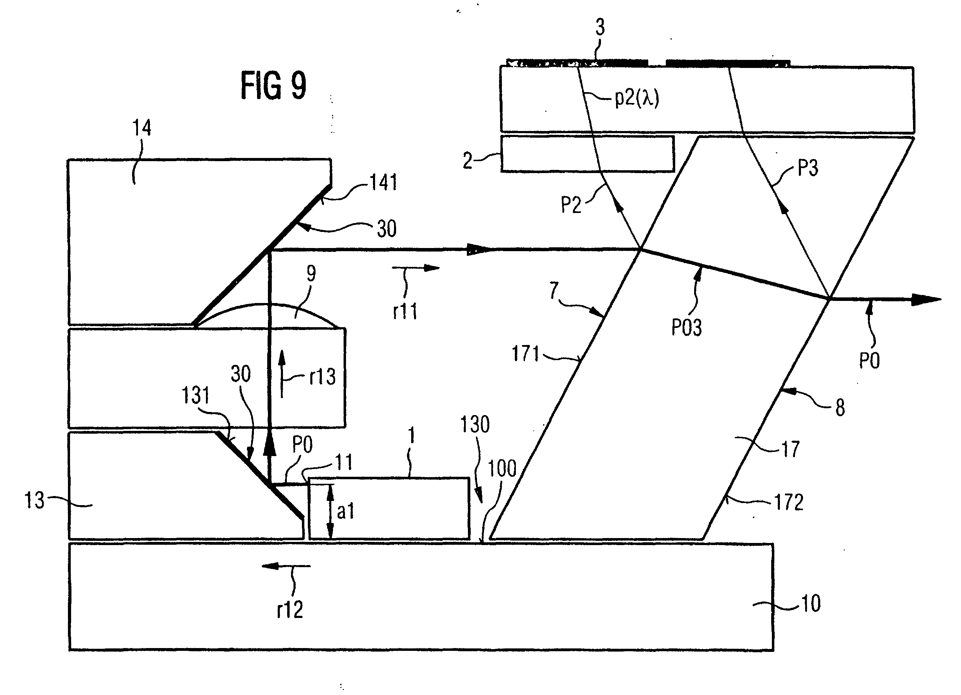

Bei der in Figur 9 dargestellten Realisierung der Ausgestaltung der Ausführungsform nach Figur 4 breitet sich die aus dem hier links angeordneten Lichtaustrittsfenster 11 des Lasers 1 austretende und für eine Nutzung bestimmte optische Leistung, welche die Gesamtleistung P0 des Lasers 1 oder eine Teilleistung P01 dieser Gesamtleistung P0 sein kann (in der Figur 9 ist nur P0 eingezeichnet), in der Richtung r12 nach links aus und trifft auf den diesem Lichtaustrittsfenster 11 gegenüberliegenden Umlenkspiegel 30 der Schicht 13. Dieser Umlenkspiegel 30 lenkt diese Leistung P0 oder P01 in die Richtung r13 nach oben zum Umlenkspiegel 30 der Schicht 14 um, von dem sie in die zur Richtung r12 entgegengesetzte Richtung r11 umgelenkt wird.

Die sich in der Richtung r11 ausbreitende Leistung P0 oder P01 trifft auf den wellenlängenneutralen Leistungsteiler 7, der die zugeführte Leistung P0 oder P01 in zwei Leistungsanteile aufspaltet, deren einer als der zu filternde Leistungsanteil P2 dem Filter 2 und andere mit P03 bezeichnete ist und für die Nutzung bestimmt ist.

Der Leistungsteiler 7 ist in Form eines teildurchlässigen Spiegels auf einer schräg in einem Winkel zur Oberfläche 100 des Substrats 10 angeordneten Fläche 171 eines auf der Oberfläche 100 angeordneten Körpers 17 aus transparentem Material, beispielsweise Glas, ausgebildet und wirkt so, daß von der zugeführten Leistung P0 oder P01 der dem Filter 2 zuzuführende zu filternde Leistungsanteil P2 reflektiert und der andere Leistungsanteil P03, der für die Nutzung bestimmt ist, transmittiert wird.

Dieser andere Leistungsanteil P03 trifft auf den weiteren wellenlängenneutralen Leistungsteiler 8, der diesen anderen Leistungsanteil P03 in zwei Leistungsanteile aufspaltet, deren einer dem weiteren Detektor 4 als der weitere Leistungsanteil P3 und andere mit P04 bezeichnet ist und für die Nutzung zur Verfügung steht.

Der weitere Leistungsteiler 8 ist ebenfalls in Form eines teildurchlässigen Spiegels auf einer schräg in einem Winkel zur Oberfläche 100 des Substrats 10 angeordneten Fläche eines auf der Oberfläche 100 angeordneten Körpers aus transparentem Material, beispielsweise Glas, ausgebildet, vorteilhafterweise nach Figur 8 auf der von der Fläche 171 abgekehrten Fläche 172 des Körpers 17, wobei der Leistungsteiler 8 so wirkt, daß von dem zugeführten Leistungsanteil P03 der dem weiteren Detektor 4 zuzuführende weitere Leistungsanteil P3 reflektiert und der mit P04 bezeichnete und für die Nutzung zur Verfügung stehende andere Leistungsanteil transmittiert wird.

Auf dem Körper 17 ist eine Trägerplatte 18 aus transparentem Material, beispielsweise Glas, angeordnet, auf der das Filter 2 und der eine und weitere Detektor 3 und 4 befestigt sind, wobei das Filter 2 aus dem zugeführten zu filternden Leistungsanteil P2 die im wesentlichen nur die zu filternde Wellenlänge λ enthaltende Leistung p2 ausfiltert, die dem einen Detektor 3 zugeführt ist.

Beispielsweise ist das Filter 2 auf einer der Oberfläche 100 des Substrats 10 zugekehrten und seitlich über den Körper 17 überstehenden Fläche 181 der Trägerplatte 18 seitlich neben dem Trägerkörper 17 befestigt, und sind die Detektoren 3 und 4 auf einer der Oberfläche 100 abgekehrten Fläche 182 der Trägerplatte 18 angeordnet, wobei die vom Filter 2 ausgefilterte Leistung p2 durch die Trägerplatte 18 hindurch dem einen Detektor 3 und der vom weiteren Leistungsteiler 8 reflektierte weitere Leistungsanteil P3 durch den Körper 7 und die Trägerplatte 18 hindurch dem weiteren Detektor 4 zugeführt ist.

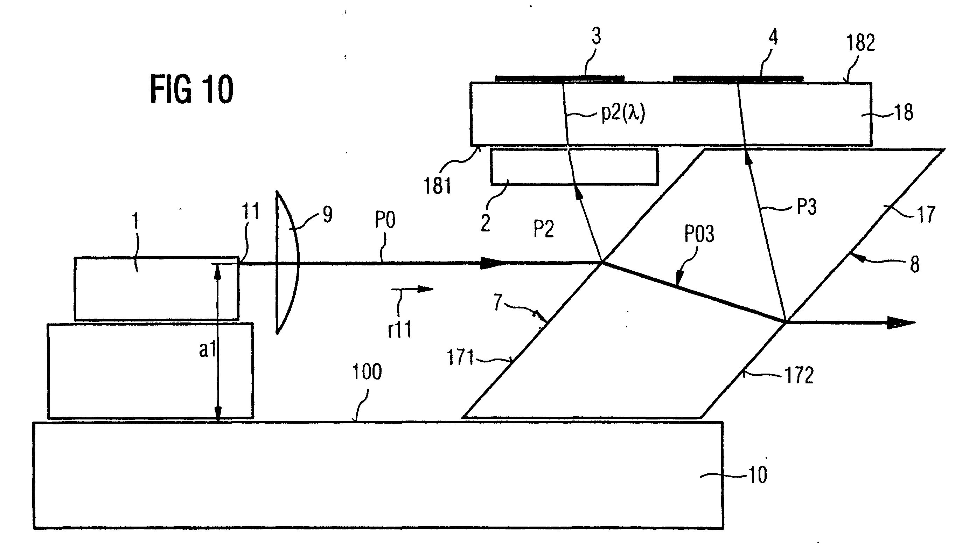

Die in Figur 10 dargestellte Realisierung der Ausgestaltung der Ausführungsform nach Figur 4 unterscheidet sich von der Realisierung nach der Figur 9 lediglich darin, auf die Umlenkspiegel 30 und damit Schichten 13 und 14 verzichtet ist. Die aus dem hier rechts angeordneten Lichtaustrittsfenster 11 des Lasers 1 austretende und für eine Nutzung bestimmte optische Gesamtleistung P0 des Lasers 1 oder Teilleistung P01 dieser Gesamtleistung P0 (auch in dieser Figur ist nur P0 eingezeichnet) breitet sich ohne eine Umlenkung in der Richtung r11 nach rechts aus und ist unmittelbar dem Leistungsteiler 7 zugeführt.

Der Laser 1 ist in ausreichendem Abstand von der Oberfläche 100 auf dem Substrat 10 befestigt.

Die Leistungsteiler 7 und/oder 8 der Realisierungen nach den Figuren 8 bis 10 weisen vorzugsweise ein Teilungsverhältnis von 90% auf, so daß 90% der dem Teiler zugeführten optischen Leistung für die Nutzung zur Verfügung stehen.

In die Realisierung nach den Figuren 7 bis 10 können vorteilhafterweise auch strahlformende Linsen integriert werden. Bei den Realisierungen nach den Figuren 7 bis 9 sind solche mit 9 bezeichneten Linsen vorteilhafterweise auf oder in einer zwischen der ersten Schicht 13 und der weiteren Schicht 14 angeordneten Zwischenschicht 16 im Bereich einer in der Schicht 13 und/oder 14 ausgebildeten Aussparung 130 und/oder 140 so realisiert, daß jede Linse 9 von einer optischen Leistung, beispielsweise P0, P01, P02, durchstrahlt wird. Bei der Realisierung nach Figur 10 ist eine Linse 9 zweckmäßigerweise direkt vor dem Lichtaustrittsfenster 11 des Lasers 1 angeordnet.

Eine Linse 9 ist beispielsweise zum Kollimieren einer optischen Leistung, beispielsweise einer für die Nutzung bestimmten Leistung, die üblicherweise in eine Systemfaser einzukoppeln ist, oder zum Konzentrieren oder Fokussieren optischer Leistung auf einem Detektor 3 und/oder 4 vorgesehen und kann z.B. eine plankonvexe Linse aus beispielsweise Silizium sein.

Bei den Realisierungen nach den Figuren 7 bis 10 trifft der zu filternde Leistungsanteil P2 schräg auf das Filter 2 auf. Dies muß beim Filterdesign berücksichtigt werden. Der Einfallswinkel des zu filternden Leistungsanteils P2 auf das Filter 2 kann bei den Realisierungen nach den Figuren 7 und 8 durch laterales Justieren der betreffenden Linse 9 geringfügig verändert werden, wodurch eine Feinjustage der Filterkurve möglich ist. Die Wellenlängenselektivität des Filters 2 hängt u.a. auch von der Strahldivergenz des einfallenden Leistungsanteils P2 ab; die höchste Selektivität wird erzielt, wenn der Strahl gut kollimiert ist.

## Patentansprüche

1. Lasermodul mit Wellenlängenstabilisierung, der umfasst
- einen Laser (1),
- ein wellenlängenselektives und auf eine zu stabilisierende Wellenlänge (λ) des Lasers (1) eingestelltes optisches Filter (2), dem ein Leistungsanteil (P2) einer vom Laser (1) abgestrahlten optischen Gesamtleistung (P0) zugeführt wird,
- einen optischen Detektor (3), dem die ausgefilterte Leistung (p2) zur Detektion zugeführt ist,
- einen weiteren optischen Detektor (4), dem eine von der abgestrahlten optischen Gesamtleistung (P0) derart abgeleiteter weiterer optischer Leistungsanteil (P3) zur Detektion zugeführt ist, daß ein Verhältnis (p2/P3) zwischen der ausgefilterten Leistung (p2) und dem weiteren Leistungsanteil (P3) unabhängig von der Gesamtleistung (P0) ist,
- eine Einrichtung (5) zur Bildung des Verhältnisses (p2/P3) zwischen der detektierten ausgefilterten Leistung (p2) und dem detektierten weiteren Leistungsanteil (P3) und
- eine Einrichtung (6) zum Vergleichen des gebildeten Verhältnisses (p2/P3) als ein Istwert mit einem Sollwert (S0) dieses Verhältnisses (p2/P3) und zum Einstellen eines Betriebsparameters (T) des Lasers (1), von dem die zu stabilisierende Wellenlänge (λ) abhängt, bei einer Abweichung des Istwerts (p2/P3) vom jeweiligen Sollwert (S0) derart, daß der Istwert (p2/P3) im wesentlichen mit dem eingestellten Sollwert (S0) übereinstimmt,
**dadurch gekennzeichnet, daß**
das Filter ein Interferenzfilter ist, das an einer Schicht (14) oder einer Trägerplatte (18) angeordnet ist, an der der optische Detektor (3) angeordnet ist,
das Filter aus dem zugeführten optischen Leistungsanteil (P2) eine im wesentlichen nur die zu stabilisierende Wellenlänge (λ) enthaltende Leistung (p2) ausfiltert und
der Sollwert einstellbar ist.

2. Lasermodul nach Anspruch 1,
**dadurch gekennzeichnet, daß**
dem Filter (2) ein zur Gesamtleistung (P0) proportionaler zu filternder Leistungsanteil (P2) zugeführt und dem weiteren Detektor (4) als weiterer Leistungsanteil (P3) ein vom Filter (2) neben der ausgefilterten Leistung (p2) abgegebener Teil des zugeführten zu filternden Leistungsanteils (P2) zugeleitet ist, wobei die Summe (P3+p2) aus diesem weiteren Leistungsanteil (P3) und der ausgefilterten Leistung (p2) gleich oder zumindest proportional zu dem zugeführten zu filternden Leistungsanteil (P2) ist.

3. Lasermodul nach Anspruch 1,
**dadurch gekennzeichnet, daß**
- ein wellenlängenneutraler optischer Leistungsteiler (7) vorhanden ist,
- der Laser (1) zwei Lichtaustrittsfenster (11, 12) zum jeweiligen Abstrahlen je einer Teilleistung (P01, P02) der vom Laser (1) erzeugten optischen Gesamtleistung (P0) aufweist, wobei die Teilleistung (P01, P02) aus einem Lichtaustrittsfenster (11, 12) für eine Nutzung bestimmt ist, daß
- die für die Nutzung bestimmte und zur Gesamtleistung (P0) proportionale Teilleistung (P01, P02) aus dem einen Lichtaustrittsfenster (11, 12) dem Leistungsteiler (7) zugeführt ist, der aus dieser Teilleistung (P01, P02) zwei Leistungsanteile erzeugt, deren einer dem Filter (2) als der zu filternde Leistungsanteil (P2) zugeführt und andere (P03) für die Nutzung zur Verfügung steht, wobei die vom Filter (2) aus dem zugeführten zu filternden Leistungsanteil (P2) ausgefilterte und im wesentlichen nur die zu stabilisierende Wellenlänge (λ) enthaltende Leistung (p2) dem einen Detektor (3) zugeführt ist, und
- die zur Gesamtleistung (P0) proportionale Teilleistung (P02, P01) aus dem anderen Lichtaustrittsfenster (12, 11) dem weiteren Detektor (4) als der weitere Leistungsanteil (P3) zugeführt ist.

4. Lasermodul nach Anspruch 1,
**dadurch gekennzeichnet, daß**
- ein wellenlängenneutraler optischer Leistungsteiler (7) vorhanden ist, dem eine zur Gesamtleistung (P0) proportionale optische Leistung (P0, P01, P02) des Lasers (1) zugeführt ist und der aus dieser zugeführten Leistung (P0, P01, P02) zwei Leistungsanteile erzeugt, deren einer (P03) für die Nutzung bestimmt ist,
- dieser eine erzeugte Leistungsanteil (P03) einem weiteren wellenlängenneutralen Leistungsteiler (8) zugeführt ist, der diesen Leistungsanteil (P03) wiederum in zwei Leistungsanteile (P04, P3) aufspaltet, deren einer (P04) für die Nutzung bestimmt ist,
- der von einem (7) der beiden Leistungsteiler (7, 8) erzeugte andere Leistungsanteil (P2) dem Filter (2) zur Filterung zugeführt und die vom Filter (2) aus diesem zu filternden, Leistungsanteil (P2) ausgefilterte und im wesentlichen nur die zu stabilisierende Wellenlänge (λ) enthaltende Leistung (p2) dem einen Detektor (3) zugeführt ist, und
- der vom anderen Leistungsteiler (8) erzeugte andere Leistungsanteil (P3) als der weitere Leistungsanteil dem weiteren Detektor (4) zugeführt ist.

## Claims

1. Laser module with wavelength stabilization, which comprises
- a laser (1),
- a wavelength-selective optical filter (2) which is set to a wavelength (λ) of the laser (1) to be stabilized and to which a power fraction (P2) of a total optical power (P0) emitted by the laser (1) is fed,
- an optical detector (3) to which the filtered-out power (p2) is fed for detection,
- a further optical detector (4), to which a further optical power fraction (P3) derived in such a way [sic] from the total optical power (P0) emitted is fed for detection that a ratio (p2/P3) of the filtered-out power (p2) to the further power fraction (P3) is independent of the total power (P0),
- a device (5) for forming the ratio (p2/P3) of the detected filtered-out power (p2) to the detected further power fraction (P3), and
- a device (6) for comparing the formed ratio (p2/P3) as an actual value with a desired value (SO) for this ratio (p2/P3) and, in the event of a deviation of the actual value (p2/P3) from the respective desired value (SO), for setting an operational parameter (T) of the laser (1), on which the wavelength (λ) to be stabilized depends, in such a way that the actual value (p2/P3) substantially corresponds to the set desired value (SO),
**characterized in that** the filter is an interference filter which is arranged on a layer (14) or a carrier plate (18) on which the optical detector (3) is arranged, the filter filters out from the fed optical power fraction (P2) a power (p2) which substantially contains only the wavelength (λ) to be stabilized and the desired value can be set.

2. Laser module according to Claim 1, **characterized in that** the filter (2) is fed a power fraction (P2) to be filtered which is proportional to the total power (P0), and the further detector (4) is supplied, as further power fraction (P3), with a portion, output by the filter (2) in addition to the filtered-out power (p2), of the fed power fraction (P2) to be filtered, the sum (P3+p2) of this further power fraction (P3) and the filtered-out power (p2) being equal or at least proportional to the fed power fraction (P2) to be filtered.

3. Laser module according to Claim 1, **characterized in that**
- a wavelength-neutral optical power divider (7) is present,
- the laser (1) has two light exit windows (11, 12) for respectively emitting one partial power (P01, P02) each of the total optical power (P0) generated by the laser (1), the partial power (P01, P02) from a light exit window (11, 12) being intended for a use, **in that**
- the partial power (P01, P02) intended for the use and proportional to the total power (P0) is fed from one light exit window (11, 12) to the power divider (7), which generates from this partial power (P01, P02) two power fractions of which one is fed to the filter (2) as the power fraction (P2) to be filtered and [lacuna] others [sic] (P03) is available for the use, the power (p2) which is filtered out by the filter (2) from the fed power fraction (P2) to be filtered and contains substantially only the wavelength (λ) to be stabilized, is fed to one detector (3) and
- the partial power (P02, P01) proportional to the total power (P0) is fed from the other light exit window (12, 11) to the further detector (4) as the further power fraction (P3).

4. Laser module according to Claim 1, **characterized in that**
- a wavelength-neutral optical power divider (7) is present which is fed optical power (P0, P01, P02) of the laser (1) which is proportional to the total power (P0), and which generates from this fed power (P0, P01, P02) two power fractions of which one (P03) is intended for the use,
- this one generated power fraction (P03) is fed to a further wavelength-neutral power divider (8), which in turn splits this power fraction (P03) into two power fractions (P04, P3) of which one (P04) is intended for the use,
- the other power fraction (P2) generated by one (7) of the two power dividers (7, 8) is fed to the filter (2) for filtering, and the power (p2) which is filtered out by the filter (2) from this power fraction (P2) to be filtered and substantially contains only the wavelength (λ) to be stabilized is fed to a detector (3) and
- the other power fraction (P3) generated by the other power divider (8) is fed to the further detector (4) as the further power fraction.

## Revendications

1. Module laser avec stabilisation de longueur d'onde, qui comprend
- un laser (1),
- un filtre optique (2) qui est sélectif en longueur d'onde, qui est réglé sur une longueur d'onde à stabiliser (λ) du laser (1) et auquel est envoyée une composante de puissance (P2) d'une puissance optique totale (P0) émise par le laser (1),
- un détecteur optique (3) auquel est envoyée pour la détection la puissance filtrée (p2),
- un autre détecteur optique (4) auquel est envoyée pour la détection une autre composante de puissance optique (P3) déduite de telle sorte de la puissance optique totale émise (P0) qu'un rapport (p2/P3) entre la puissance filtrée (p2) et l'autre composante de puissance (P3) est indépendant de la puissance totale (P0),
- un dispositif (5) pour former le rapport (p2/P3) entre la puissance filtrée détectée (p2) et l'autre composante de puissance détectée (P3) et
- un dispositif (6) pour comparer le rapport formé (p2/P3) en tant que valeur réelle à une valeur de consigne (S0) de ce rapport (p2/P3) et pour régler de telle sorte un paramètre de fonctionnement (T) du laser (1) dont dépend la longueur d'onde à stabiliser (λ), en cas d'écart entre la valeur réelle (p2/P3) et la valeur de consigne respective (S0), que la valeur réelle (p2/P3) coïncide globalement avec la valeur de consigne réglée (S0)
**caractérisé par le fait que**
le filtre est un filtre d'interférence qui est disposé sur une couche (14) ou un support (18) sur lequel le détecteur optique (3) est placé,
le filtre filtre de la composante de puissance optique envoyée (P2) une puissance (p2) ne contenant globalement que la longueur d'onde à stabiliser (λ) et
la valeur de consigne est réglable.

2. Module laser selon la revendication 1,
**caractérisé par le fait que** le filtre (2) reçoit une composante de puissance (P2) à filtrer proportionnelle à la puissance totale (P0) et que l'autre détecteur (4) reçoit comme autre composante de puissance (P3) une partie, délivrée par le filtre (2) à côté de la puissance filtrée (p2), de la composante de puissance à filtrer envoyée (P2), la somme (P3 + p2) de cette autre composante de puissance (P3) et de la puissance filtrée (p2) étant égale ou au moins proportionnelle à la composante de puissance à filtrer envoyée (P2).

3. Module laser selon la revendication 1,
**caractérisé par le fait que**
- il est prévu un diviseur de puissance optique (7) neutre en longueur d'onde,
- le laser (1) comporte deux fenêtres de sortie de lumière (11, 12) pour l'émission respective à chaque fois d'une puissance partielle (P01, P02) de la puissance optique totale (P0) produite par le laser (1), la puissance partielle (P01, P02) issue d'une fenêtre de sortie de lumière (11, 12) étant destinée à une utilisation,
- la puissance partielle (P01, P02) destinée à une utilisation et proportionnelle à la puissance totale (P0) est envoyée d'une fenêtre de sortie de lumière (11, 12) au diviseur de puissance (7) qui produit à partir de cette puissance partielle (P01, P02) deux composantes de puissance dont l'une est envoyée au filtre (2) comme étant la composante de puissance à filtrer (P2) et dont l'autre (P03) est disponible pour l'utilisation, la puissance (p2) qui est filtrée par le filtre (2) à partir de la composante de puissance à filtrer envoyée (P2) et qui ne contient globalement que la longueur d'onde à stabiliser (λ) étant envoyée au détecteur (3), et
- la puissance partielle (P02, P01) proportionnelle à la puissance totale (P0) est envoyée de l'autre fenêtre de sortie de lumière (12, 11) à l'autre détecteur (4) comme étant l'autre composante de puissance (P3).

4. Module laser selon la revendication 1,
**caractérisé par le fait que**
- il est prévu un diviseur de puissance optique (7) qui est neutre en longueur d'onde, auquel est envoyée une puissance optique (P0, P01, P02), proportionnelle à la puissance totale (P0), du laser (1) et qui produit à partir de cette puissance envoyée (P0, P01, P02) deux composantes de puissance dont l'une (P03) est destinée à l'utilisation,
- cette composante de puissance produite (P03) est envoyée à un autre diviseur de puissance (8) qui est neutre en longueur d'onde et qui divise à nouveau cette composante de puissance (P03) en deux composantes de puissance (P04, P3) dont l'une (P04) est destinée à l'utilisation,
- l'autre composante de puissance (P2) produite par l'un (7) des deux diviseurs de puissance (7, 8) est envoyée au filtre (2) pour le filtrage et la puissance (p2) filtrée par le filtre (2) à partir de cette composante de puissance à filtrer (P2) et ne contenant globalement que la longueur d'onde à stabiliser (λ) est envoyée au détecteur (3), et
- l'autre composante de puissance (P3) produite par l'autre diviseur de puissance (8) est envoyée comme étant l'autre composante de puissance à l'autre détecteur (4).
